# EUROPEAN PATENT SPECIFICATION

(11) **EP 3 965 143 B1**
(45) Date of publication and mention of the grant of the patent: **18.10.2023**
(21) Application number: 21802178.0
(22) Date of filing: 24.05.2021
(51) Int. Cl.: H01L 21/28, H01L 29/49

(54) **PREPARATION METHOD FOR SEMICONDUCTOR STRUCTURE AND SEMICONDUCTOR STRUCTURE**
HERSTELLUNGSVERFAHREN FÜR HALBLEITERSTRUKTUR UND HALBLEITERSTRUKTUR
PROCÉDÉ DE PRÉPARATION POUR UNE STRUCTURE SEMI-CONDUCTRICE ET STRUCTURE SEMI-CONDUCTRICE

(30) Priority: 10.07.2020 CN 202010663904
(43) Date of publication of application: 09.03.2022
(73) Proprietor: Changxin Memory Technologies, Inc., Hefei City, Anhui 230000 (CN)
(72) Inventor: WU, Gongyi, Hefei City, Anhui 230000 (CN); YU, Youquan, Hefei City, Anhui 230000 (CN); LU, Yong, Hefei City, Anhui 230000 (CN)
(74) Representative: Lavoix
(86) International application number: PCT/CN2021/095570
(87) International publication number: WO 2022/007521

(56) References cited:
- CN-A- 1 619 776
- KR-A- 20090 104 252
- KR-A- 20090 105 444
- KR-A- 20100 003 833
- KR-A- 20130 082 374
- US-A1- 2008 213 990
- US-A1- 2012 282 769

## Description

This application is proposed based on Chinese patent application No. 202010663904.8 filed on July 10, 2020, and claims priority to this Chinese patent application.

### TECHNICAL FIELD

This disclosure relates to the field of semiconductors, and particularly relates to a method for manufacturing a semiconductor structure and the semiconductor structure manufactured by this method.

### BACKGROUND

With the increase in the integration level of semiconductor devices, it is usually to manufacture a Dynamic Random Access Memory (DRAM) with a gigabit storage capacity. In order to reduce the Resistance-Capacitance (RC) delay in a gate of a device, it is usually to use a metal/polysilicon gate with a stacked structure. During the etching process of a nano-gate, the difficulty of nano-gate etching control lies in the control on key parameters such as the gate or key dimensions. For example, in the manufacturing process of the metal/polysilicon gate, after a gate structure is formed by dry etching and before a protective layer is formed on a surface of the metal/polysilicon gate, the metal/polysilicon gate will be exposed, and the metal/polysilicon gate will be oxidized. The longer the metal/polysilicon gate is exposed, the more serious the oxidation will be. Subsequently, when the metal/polysilicon gate is subjected to wet cleaning by diluted HF, oxide layers on the metal side wall of the cannot be removed and are easy to form protrusions, while oxide layers on the polysilicon side wall can be removed and are easy to form recesses. This will cause uneven side wall with protrusions and recesses of the gate structure and deformation of the gate structure, and ultimately affect the electrical performance of the device and cause poor reliability of the semiconductor device, resulting in the loss of yield and performance of the final device.

KR 2009 0105444 A discloses a method for manufacturing a transistor of a semiconductor device, wherein a gate insulation layer and a gate conductive layer are formed on a semiconductor substrate. A diffusion barrier layer with Ti, a metal layer, and a hard mask layer are formed on the gate conductive layer. A hard mask pattern is formed by patterning the hard mask layer. A gate stack is formed by an etching process using the hard mask pattern as a mask. The plasma nitriding is performed on a diffusion barrier layer pattern and a metal layer pattern without exceeding an oxidation critical temperature. A selective oxidation process for forming a compensation layer is performed in the side wall of a gate conductive layer pattern. A spacer is formed in the side wall of a gate stack.

Therefore, how to avoid the above situation has become an urgent problem to be solved at present.

### SUMMARY

The technical problem to be solved by this disclosure is to provide a method for manufacturing a semiconductor structure and a semiconductor structure. Through the present disclosure, the deformation of a gate structure can be avoided and the reliability of a semiconductor device can be improved.

In order to solve the above problem, according to the present invention there are provided a method for manufacturing a semiconductor structure and a semiconductor structure according to the appended set of claims.

This disclosure has the following advantages. Specifically, the first protective layer is first formed on the surface of the gate structure, and then, an isolation layer is formed to prevent the gate structure from being oxidized. Therefore, the gate structure has a flat side wall structure, and is not deformed, thereby greatly improving the reliability of the semiconductor device, and the yield and performance of the final device.

### BRIEF DESCRIPTION OF THE DRAWINGS

FIG. 1 schematically illustrates operations of a method for manufacturing a semiconductor structure according to one example of the disclosure.
FIG. 2 to FIG. 14 illustrate a flowchart of a method for preparing a semiconductor structure according to one example of the disclosure respectively.

### Reference signs in the drawings:

100: gate structure; 110: isolation layer;
200: semiconductor substrate;
300: gate insulation layer;
400: first conductive layer; 401: second protective layer; 402: structural layer;
500: barrier layer;
600: second conductive layer; 601:first protective layer;
700: passivation layer; 701: mask layer; 702: photoresist layer;
800: primary gate pattern;
900: initial dielectric layer; 901: dielectric layer.

### DETAILED DESCRIPTION

The embodiments of a method for manufacturing a semiconductor structure and the semiconductor structure provided by this disclosure will be described in detail below with reference to the drawings.

This disclosure provides method for manufacturing a semiconductor structure, which can avoid the deformation of a gate structure and improve the reliability of a semiconductor device.

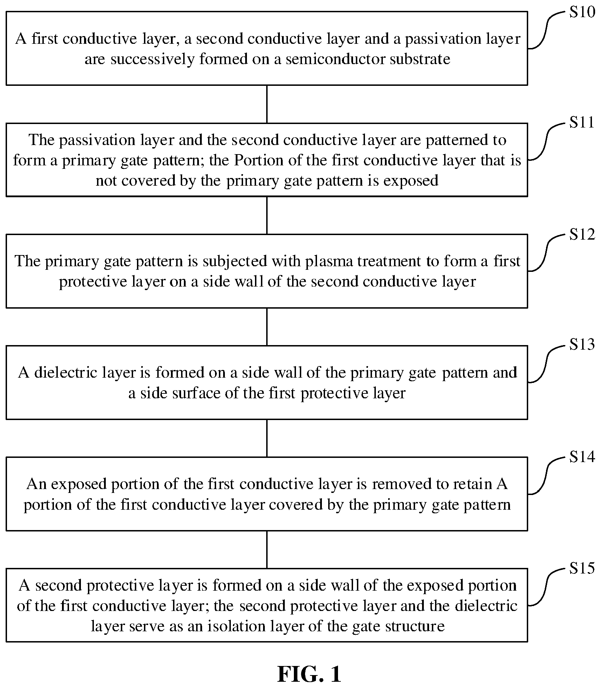

FIG. 1 is schematically illustrates operations of a method for manufacturing a semiconductor structure according to one example of the disclosure. Referring to FIG. 1, the method for manufacturing a semiconductor structure of the disclosure includes the following operations. At S10, a first conductive layer, a second conductive layer, and a passivation layer are successively formed on a semiconductor substrate. At S11, the passivation layer and the second conductive layer are patterned to form a primary gate pattern, and a region of the first conductive layer that is not shielded by the primary gate pattern, is exposed. At S12, plasma treatment is performed on the primary gate pattern to form a first protective layer on a side wall of the second conductive layer. At S13, a dielectric layer is formed on a side wall of the primary gate pattern and a side surface of the first protective layer. At S14, the exposed portion of the first conductive layer is removed to retain the first conductive layer covered by the primary gate pattern. And, at S15, a second protective layer is formed on a side wall of the exposed portion of the first conductive layer, and the second protective layer and the dielectric layer serve as an isolation layer of the gate structure.

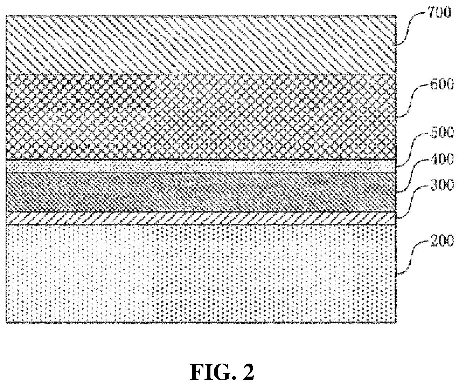

FIG. 2 to FIG. 14 illustrate a flowchart of a method for preparing a semiconductor structure according to one example of the disclosure respectively.

Referring to S10 and FIG. 2, a first conductive layer 400, a second conductive layer 600 and a passivation layer 700 are successively formed on a semiconductor substrate 200. Further, in this example, a gate insulation layer 300 is further formed on the semiconductor substrate, and a barrier layer 500 is formed between the first conductive layer 400 and the second conductive layer 600.

The material of the semiconductor substrate 200 may be made of a material such as silicon (Si), germanium (Ge), silicon germanium (GeSi) or silicon carbide (SiC), may also be silicon-on-insulator (SOI) or germanium-on-insulator (GOI), or may also be other materials, such as other group III-V compounds (e.g., gallium arsenide). The semiconductor substrate 200 may be arranged with devices.

The gate insulation layer 300 may be made of silicon oxide, germanium oxide, etc. The gate insulation layer 300 may be formed on the semiconductor substrate 200 by means of such as thermal oxidation.

The first conductive layer 400 may be formed on the gate insulation layer 300 by processes such as chemical vapor deposition. The first conductive layer 400 is a conductive layer containing silicon, such as polysilicon. If the first conductive layer 400 is oxidized, the formed oxide can be easily removed by an etching solution.

The barrier layer 500 is configured to prevent the material of the second conductive layer 600 from diffusing to the first conductive layer 400. The barrier layer 500 may be formed by a chemical vapor deposition process or an atomic layer deposition process, and the material of the barrier layer 500 may be titanium nitride, tungsten nitride, or the like.

The second conductive layer 600 may be formed by a chemical vapor deposition process or a physical vapor deposition process. In this example, the second conductive layer 600 is a metal tungsten layer.

The passivation layer 700 may be formed by a chemical vapor deposition process or an atomic layer deposition process, and may be a silicon nitride (SiN) layer, a silicon boron nitride (SiBN) layer, or a silicon oxynitride (SiON) layer. In this example, the passivation layer 700 is a silicon nitride layer.

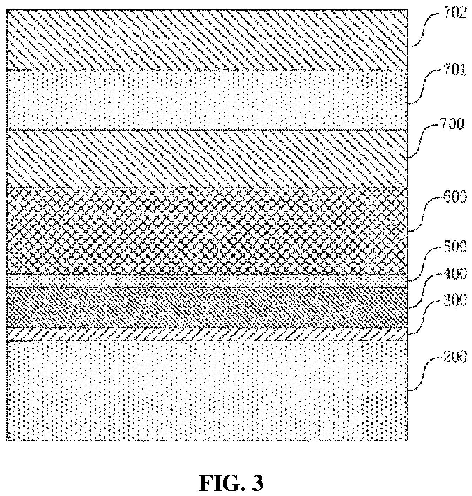

Referring to S11 and FIG. 3 to FIG. 7, the passivation layer 700 and the second conductive layer 600 are patterned to form a primary gate pattern 800, and a region of the first conductive layer 400 that is not shielded by the primary gate pattern 800, is exposed. It can be understood that in this operation, the barrier layer 500 is also patterned.

This example provides a method for forming the primary gate pattern 800.

Referring to FIG. 3, a mask layer 701 and a photoresist layer 702 are formed on the passivation layer 700. The mask layer 701 may include silicon oxynitride as a Dielectric Anti-Reflection Coating (DARC), and an amorphous carbon (a-C) layer as a pattern layer. In some examples, a Bottom Anti-Reflection Coating (BARC) and a Photo Resist (PR) may also be deposited on the mask layer 701. The photoresist layer 702 is formed on the BARC.

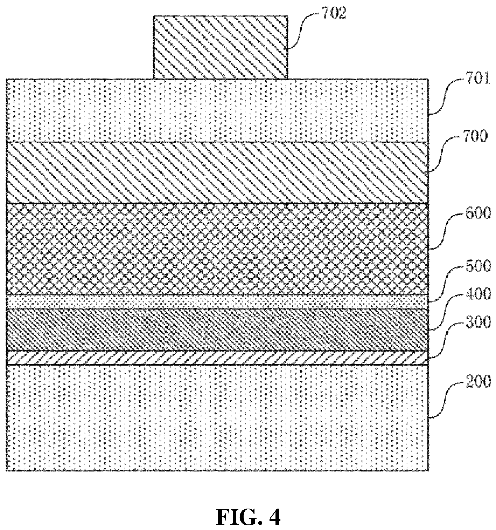

Referring to FIG. 4, the photoresist layer 702 is patterned, and the photoresist layer located at the region where the primary gate pattern 800 needs to be formed is retained.

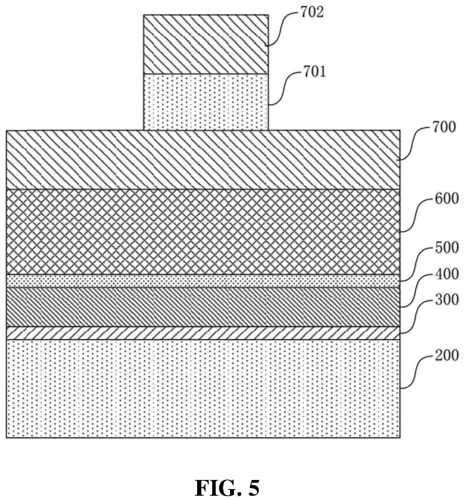

Referring to FIG. 5, a pattern of the photoresist layer 702 is transferred to the mask layer 701 to form a patterned mask layer. A region shielded by the mask layer 701 is used as the region where the primary gate pattern 800 needs to be formed subsequently.

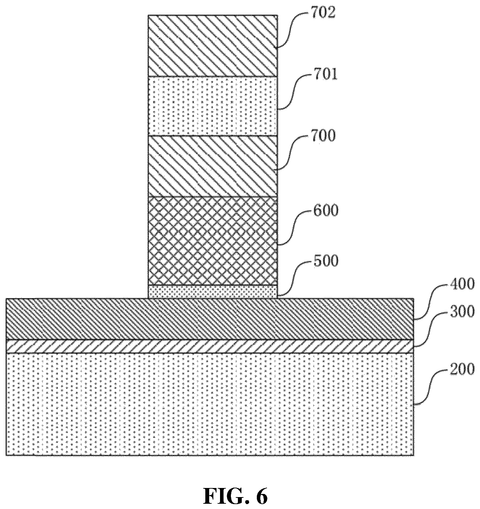

Referring to FIG. 6, the passivation layer 700, the second conductive layer 600 and the barrier layer 500 are removed by taking the mask layer 701 as a mask. In this operation, the passivation layer 700, the second conductive layer 600 and the barrier layer 500 may be removed by a dry etching process. Portions of the passivation layer 700, the second conductive layer 600 and the barrier layer 500 shielded by the mask layer 701 are retained.

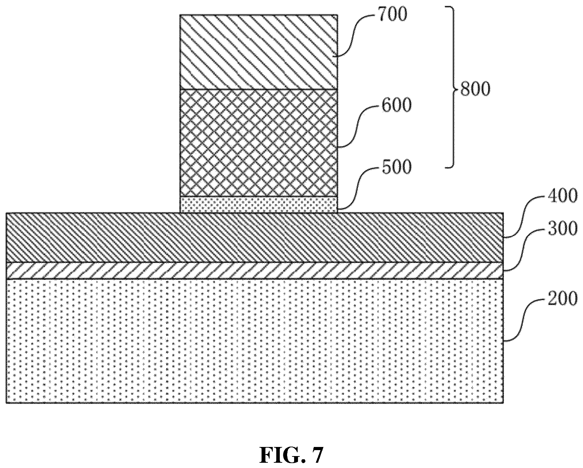

Referring to FIG. 7, the mask layer 701 and the photoresist layer 702 are removed to form the primary gate pattern 800. It can be understood that during the above operations, the photoresist layer 702 and the mask layer 701 are also consumed, so that the remaining portions of the photoresist layer 702 and the mask layer 701 are removed in this operation.

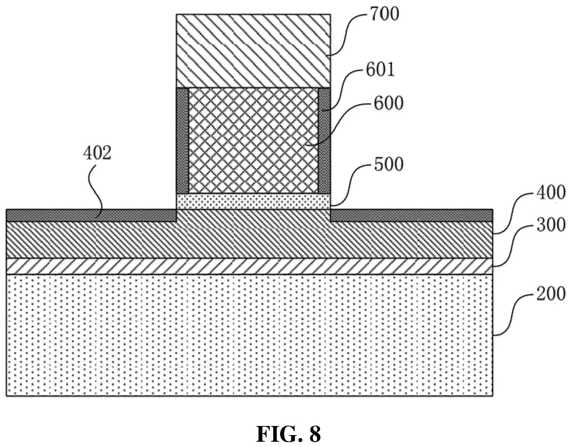

Referring to S12 and FIG. 8, plasma treatment is performed on the primary gate pattern 800 to form a first protective layer 601 on the side wall of the second conductive layer 600. In this operation, on the side wall of the second conductive layer 600, the second conductive layer 600 reacts with plasma to form the first protective layer 601. For example, if the second conductive layer 600 is made of metal tungsten and the plasma is a mixture of nitrogen and oxygen, the first protective layer 601 containing nitrogen, oxygen, and tungsten is formed on the side wall of the second conductive layer 600. In the plasma, the content of oxygen is lower than the content of nitrogen, so as to facilitate the formation of the first protective layers 601. It can be understood that due to the limitation of the manufacturing process, during the plasma treatment, the first protective layers 601 are formed not only on the side wall of the second conductive layer 600 precisely, but the plasma treatment is also performed on the exposed surface of the first conductive layer 400 and the surfaces of the barrier layer 500 and the passivation layer 700 to form a structural layer. Since the structural layer formed on the surfaces of the barrier layer 500 and the passivation layer 700 are thinner, the structural layer is not shown in FIG. 8. In FIG. 8, only the first protective layer 601 and structural layer 402 on the surface of polysilicon are shown. Further, in this operation, plasma treatment on the side wall of the primary gate pattern is performed by in-situ plasma treatment. That is, plasma treatment is directly performed in a process chamber for forming the primary gate pattern. The primary gate pattern 800 formed at S11 can be prevented from being exposed for a long time, the side wall of the second conductive layer 600 can be prevented from being oxidized. Therefore, the side wall of the gate structure would not uneven, the gate structure cannot be deformed, thereby improving the reliability of the semiconductor device and improving the yield and performance of the final device.

Further, a thickness of the first protective layer 601 is 3 angstroms to 20 angstroms. If the first protective layer 601 is too thin, the purpose of preventing the second conductive layer 600 from being oxidized cannot be achieved. If the first protective layer 601 is too thick, the thickness of the second conductive layer 600 would be too small, which affects the resistance of the gate and thus the performance of the device.

Further, after S12 is performed, a cleaning operation is also included to remove by-products and the like generated in the plasma treatment. In this example, a solution used in the cleaning step is a diluted hydrofluoric acid solution. In other examples of this disclosure, other cleaning solutions may be used.

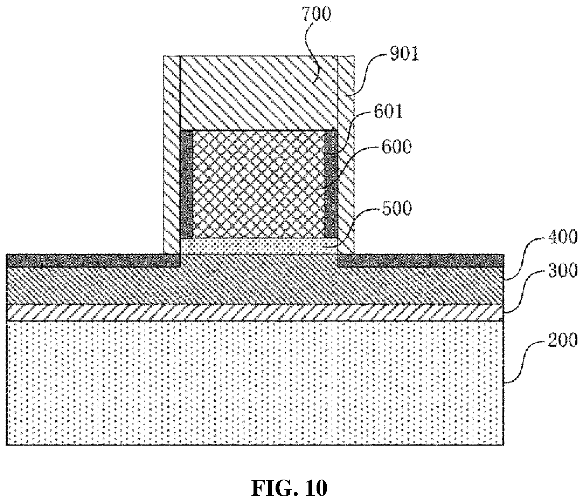

Referring to S13 and FIG. 10, a dielectric layer 901 is formed on the side wall of the primary gate pattern 800 and the side surface of the first protective layer 601.

A method for forming the dielectric layers 901 is provided in this example. The method is specifically described as follows.

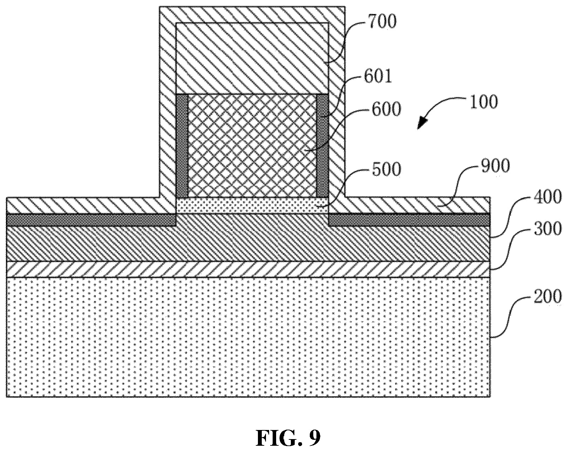

Referring to FIG. 9, an initial dielectric layer 900 is formed on the surface of the primary gate pattern 800 and the surface of the exposed portion of the first conductive layer 400. In this operation, the initial dielectric layer 900 may be formed by a chemical vapor deposition process or an atomic layer deposition process. The initial dielectric layer 900 may be a silicon nitride (SiN) layer, a silicon boron nitride (SiBN) layer, or a silicon oxynitride (SiON) layer. In this example, the initial dielectric layer 900 is a silicon nitride layer. The initial dielectric layer 900 covers the upper surface and the side wall of the primary gate pattern 800 and the surface of the exposed portion of the first conductive layer 400.

Referring to FIG. 10, part of the initial dielectric layer 900 is removed to retain portion of the initial dielectric layer on the side wall of the primary gate pattern 800 to serve as the dielectric layers 901. Specifically, the portion of the initial dielectric layer 900 covering the first conductive layer 400 is removed by dry etching, and thus the portion of the initial dielectric layer on the side wall of the primary gate pattern 800 is retained. In this operation, the portion of the initial dielectric layer 900 on the upper surface of the primary gate pattern 800 is also removed.

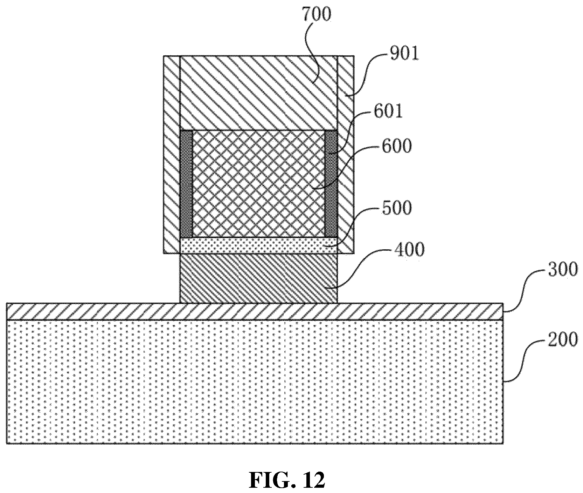

Referring to S14 and FIG. 12, the exposed portion of the first conductive layer 400 is removed to retain the portion of the first conductive layer 400 covered by the primary gate pattern 800.

Specifically, in this example, this operation is performed as follows.

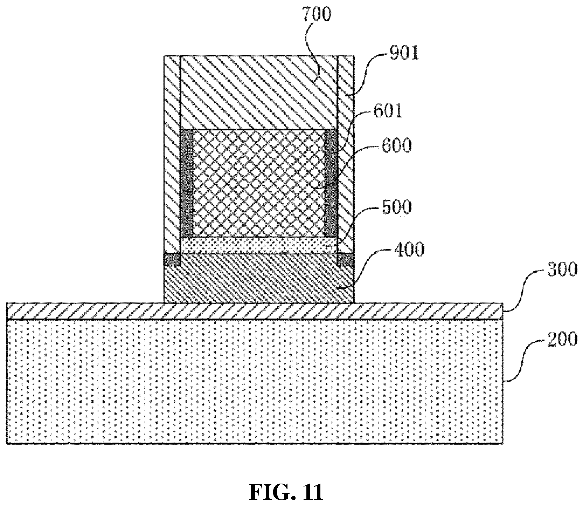

Referring to FIG. 11, the exposed portion of the first conductive layer 400 is removed by dry etching to expose the gate insulation layer 300 and the side wall of the first conductive layer 400, as well as to retain the portion of the first conductive layer 400 covered by the primary gate pattern 800 and the portion of the first conductive layer 400 below the dielectric layer 901 on the side wall of the primary gate pattern 800.

Referring to FIG. 12, the portion of the first conductive layer 400 below the dielectric layers 901 on the side wall of the primary gate pattern 800 is removed from the side wall of the first conductive layer 400 by an isotropic etching process, to retain the portion of the first conductive layer 400 covered by the primary gate pattern 800. After this operation, the side wall of the first conductive layer 400 is flush with the outer side surface of the first protective layer 601.

The second conductive layer 600, the barrier layer 500 and the first conductive layer 400 serve as a gate structure 100.

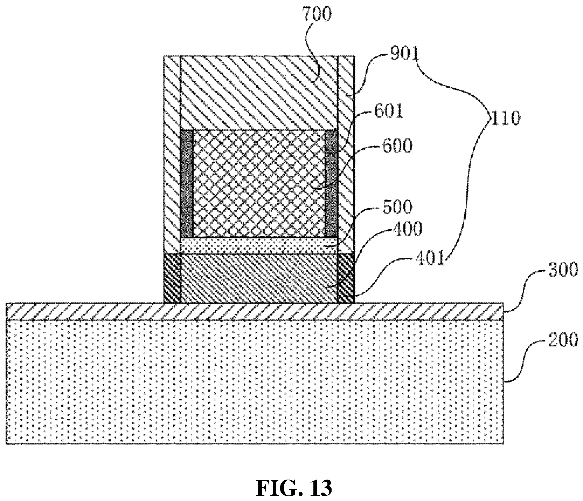

Referring to S15 and FIG. 13, a second protective layer 401 is formed on the side wall of the exposed portion of the first conductive layer 400. The second protective layer 401 and the dielectric layer 901 serve as an isolation layer 110 of the gate structure 100.

Specifically, in this example, SiC is formed on the side wall of the exposed portion of the first conductive layer 400 by means of epitaxial growth, and can be used as the second protective layer 401. By means of epitaxial growth, the structural layer can be controllably grown only on the side wall of the exposed portion of the first conductive layer 400, but no structural layer is grown on the surfaces of the gate insulation layer 300 and the dielectric layer 901. In this way, subsequent operations of removing the structural layer on the surface of the gate insulation layer 300 and the dielectric layer 901 can be avoided, thereby simplifying the process and saving the process cost. In addition, the compactness of SiC formed by means of epitaxial growth is better than the compactness of silicon oxide formed by processes such as thermal oxidation, so as to play a good blocking role to prevent the first conductive layer 400 from being damaged in the subsequent processes.

After this operation, the outer side surface of the second protective layer 401 is flush with the outer side surface of the dielectric layer 901.

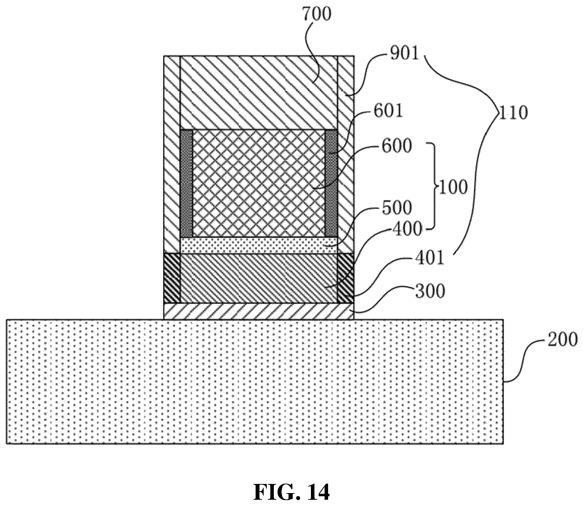

Further, in this example, the method further includes an operation of removing the gate insulation layer. Referring to FIG. 14, the portion of the gate insulation layer 300 that is not covered by the gate structure 100 and the isolation layers 110 is removed to expose the semiconductor substrate 200. The gate insulation layer 300 may be removed by a dry etching process.

After the structure shown in FIG. 14 is formed, the semiconductor structure can be subjected to a re-oxidizing treatment to improve the reliability of the gate insulation layer 300. During the re-oxidation treatment, the isolation layer 110 can protect the gate structure from being oxidized.

The method for manufacturing the semiconductor structure of this disclosure can prevent the gate structure from being oxidized, thereby avoiding the deformation of the gate structure, and improving the reliability of the semiconductor device.

This disclosure further provides a semiconductor structure manufactured by the above method. Referring to FIG. 14, the semiconductor structure includes a semiconductor substrate 200, a gate structure 100 and isolation layer 110.

In this example, the semiconductor structure further includes a gate insulation layer 300, and the gate insulation layer 300 is arranged between the semiconductor substrate 200 and the gate structure 100.

The material of the semiconductor substrate 200 may be silicon (Si), germanium (Ge), silicon germanium (GeSi) or silicon carbide (SiC), may also be silicon-on-insulator (SOI) or germanium-on-insulator (GOI), or may also be other materials, such as gallium arsenide and other group III-V compounds. The semiconductor substrate 200 may also be arranged with devices.

The gate insulation layer 300 is arranged on the semiconductor substrate 200 and can be used as an insulation layer between the semiconductor substrate 200 and the gate structure 100. In this example, only the surface of the semiconductor substrate 200 corresponding to the gate structure 100 and the isolation layer 110 is covered by the gate insulation layer 300, but other region thereof is not covered by the gate insulation layer 300.

The gate structure 100 is arranged on the gate insulation layer 300. The gate structure 100 includes a first conductive layer 400, a barrier layer 500, a second conductive layer 600 and a passivation layer 700 which are arranged in sequence. The first protective layer 601 formed by plasma treatment is arranged on the side wall of the second conductive layer 600. The first conductive layer 400 is in contact with the gate insulation layer 300.

The isolation layer 110 is formed on the side wall of the gate structure 100. The isolation layer 110 is composed of the second protective layer 401 covering the first conductive layer 400 and the dielectric layer 901 covering the barrier layer 500, the first protective layer 601 and the passivation layer 700. The dielectric layer 901 and the passivation layer 700 may be made of the same material, such as a silicon nitride material. The second protective layer 401 is made of a silicide generated by an epitaxial reaction of polysilicon.

Further, in this example, the side surface of the gate insulation layer 300 is flush with the outer side surface of the isolation layer 110. That is, the gate insulation layer 300 is only located below the isolation layer 110 and the gate structure 100. It can be understood that in other examples of this disclosure, the width of the gate insulation layer 300 is greater than the width of the isolation layer 110 and the width of the gate structure 100. That is, the gate insulation layer 300 is not only located below the isolation layer 110 and the gate structure 100, but also located in a part of the region other than below the isolation layer 110 and the gate structure 100.

The side surfaces of the first conductive layer 400, the barrier layer 500, the first protective layer 601 and the passivation layer 700 are flush, so that the gate structure 100 is a structure having a flat side surface, thereby avoiding the uneven side surface, and greatly improving the reliability of the semiconductor device.

Further, the thickness of the first protective layer 601 is 3 angstroms to 20 angstroms. If the first protective layer 601 is too thin, the purpose of preventing the second conductive layer 600 from being oxidized cannot be achieved. If the first protective layer 601 is too thick, the thickness of the second conductive layer 600 is too small, which affects the resistance of the gate and further affects the performance of the device.

Further, the outer side surfaces of the second protective layer 401 and the dielectric layer 901 are flush. That is, the outer side surface of the isolation layer 110 is of a flat structure, and the uneven condition is avoided.

The side wall of the gate structure of the semiconductor structure of this application is flat, the gate structure is not deformed, the reliability of the semiconductor device is greatly improved, and the yield and performance of the final device are further improved.

## Claims

1. A method for manufacturing a semiconductor structure, the method comprising:
successively forming (S10) a first conductive layer (400), a second conductive layer (600) and a passivation layer (700) on a semiconductor substrate (200);
patterning (S11) the passivation layer (700) and the second conductive layer (600) to form a primary gate pattern (800), wherein a portion of the first conductive layer (400) that is not covered by the primary gate pattern (800) is exposed;
subjecting (S12) the primary gate pattern (800) with a plasma treatment to form a first protective layer (601) on a side wall of the second conductive layer (600);
forming (S13) a dielectric layer (901) on a side wall of the primary gate pattern (800) and a side surface of the first protective layer (601);
removing (S14) the exposed portion of the first conductive layer (400) to retain a portion of the first conductive layer (400) covered by the primary gate pattern (800); and
forming (S15) a second protective layer (401) on a side wall of the exposed portion of the first conductive layer (400), wherein the second protective layer (401) and the dielectric layer (901) serve as an isolation layer (110) of the gate structure (100).

2. The method for manufacturing the semiconductor structure of claim 1, wherein said patterning (S11) the passivation layer (700) and the second conductive layer (600) to form the primary gate pattern (800) further comprises:
forming a mask layer (701) and a photoresist layer (702) on the passivation layer (700);
patterning the photoresist layer (702), wherein the photoresist layer (702) at a region where the primary gate pattern (800) needs to be formed is retained;
transferring the pattern of the photoresist layer (702) to the mask layer (701) to form a patterned mask layer;
removing the passivation layer (700) and the second conductive layer (600) by taking the mask layer (701) as a mask; and
removing the mask layer (701) and the photoresist layer (702) to form the primary gate pattern (800).

3. The method for manufacturing the semiconductor structure of claim 1, wherein the primary gate pattern (800) is subjected with the plasma treatment by performing nitrogen and oxygen mixed plasma treatment on the side wall of the primary gate pattern (800).

4. The method for manufacturing the semiconductor structure of claim 1, wherein the primary gate pattern (800) is subjected with the plasma treatment by in-situ plasma treatment.

5. The method for manufacturing the semiconductor structure of claim 1, wherein the formation of the dielectric layer (901) on the side wall of the primary gate pattern (800) and the side surface of the first protective layer (601) further comprises:
forming an initial dielectric layer (900) on a surface of the primary gate pattern (800) and a surface of the exposed portion of the first conductive layer (400); and
removing part of the initial dielectric layer (900) to retain a portion of the initial dielectric layer (900) on the side wall of the primary gate pattern (800) to serve as the dielectric layer (901).

6. The method for manufacturing the semiconductor structure of claim 5, wherein said removing the exposed portion of the first conductive layer (400) to retain the portion of the first conductive layer (400) located below the primary gate pattern (800) further comprises:
removing the exposed portion of the first conductive layer (400) to expose the semiconductor substrate (200), wherein a side wall of the first conductive layer (400) is exposed, and a portion of the first conductive layer (400) covered by the primary gate pattern (800) and the first conductive layer (400) below the dielectric layer (901) on the side wall of the primary gate pattern (800) are retained; and
removing the first conductive layer (400) below the dielectric layer (901) on the side wall of the primary gate pattern (800) from the side wall of the first conductive layer (400), wherein the first conductive layer (400) covered by the primary gate pattern (800) is retained.

7. The method for manufacturing the semiconductor structure of claim 1, wherein the formation of the second protective layer (401) on a side wall of the exposed portion of the first conductive layer (400) is performed by epitaxially generating the second protective layer (401) on the side wall of the exposed portion of the first conductive layer (400).

8. The method for manufacturing the semiconductor structure of claim 1, further comprising, forming a gate insulation layer (300) on the semiconductor substrate (200), wherein the gate insulation layer (300) is located between the semiconductor substrate (200) and the first conductive layer (400), and
after forming the second protective layers (401), further comprising: removing the gate insulation layer (300) which is neither covered by the first conductive layer (400) nor by the second protective layer (401) to expose the semiconductor substrate (200).

9. The method for manufacturing the semiconductor structure of claim 1, further comprising, forming a barrier layer (500) between the first conductive layer (400) and the second conductive layer (600), and wherein in the patterning of the passivation layer (700) and the second conductive layer (600), the barrier layer (500) is also patterned.

10. A semiconductor structure, wherein the semiconductor structure comprises:
a semiconductor substrate (200);
a gate structure (100) located on the semiconductor substrate (200), wherein the gate structure (100) comprises a first conductive layer (400), a second conductive layer (600) and a passivation layer (700) which are stacked, and a first protective layer (601) are arranged on a side wall of the second conductive layer (600);
a second protective layer (401) covering a side wall of the first conductive layer (400);
a dielectric layer (901) covering side walls of the first protective layer (601) and the passivation layer (700); and
a barrier layer (500) arranged between the first conductive layer (400) and the second conductive layer (600);
wherein side surfaces of the first conductive layer (400), the barrier layer (500), the first protective layer (601) and the passivation layer (700) are flush.

11. The semiconductor structure of claim 10, further comprising a gate insulation layer (300) arranged between the semiconductor substrate (200) and the gate structure (100), and a side surface of the gate insulation layer (300) is flush with an outer side surface of the second protective layer (401).

12. The semiconductor structure of claim 10, wherein a thickness of the first protective layer (601) is 3 angstroms to 20 angstroms.

13. The semiconductor structure of claim 10, wherein both the dielectric layer (901) and the passivation layer (700) are silicon nitride layers.

14. The semiconductor structure of claim 10, wherein an outer side surface of the second protective layer (401) is flush with an outer side surface of the dielectric layer (901), or
the second protective layer (401) is a silicon carbide epitaxial layer.

## Patentansprüche

1. Verfahren zum Herstellen einer Halbleiterstruktur, das Verfahren umfassend:
Aufeinanderfolgendes Bilden (S10) einer ersten leitenden Schicht (400), einer zweiten leitenden Schicht (600) und einer Passivierungsschicht (700) auf einem Halbleitersubstrat (200);
Strukturieren (S11) der Passivierungsschicht (700) und der zweiten leitenden Schicht (600), um ein primäres Gate-Muster (800) zu bilden, wobei ein Abschnitt der ersten leitenden Schicht (400), der nicht von dem primären Gate-Muster (800) bedeckt ist, freigelegt ist;
Unterziehen (S12) des primären Gate-Musters (800) einer Plasmabehandlung, um eine erste Schutzschicht (601) auf einer Seitenwand der zweiten leitenden Schicht (600) zu bilden;
Bilden (S13) einer dielektrischen Schicht (901) auf einer Seitenwand des primären Gate-Musters (800) und einer Seitenfläche der ersten Schutzschicht (601);
Entfernen (S14) des freiliegenden Abschnitts der ersten leitenden Schicht (400), um einen Abschnitt der ersten leitenden Schicht (400), der von dem primären Gate-Muster (800) bedeckt ist, beizubehalten; und
Bilden (S15) einer zweiten Schutzschicht (401) auf einer Seitenwand des freiliegenden Abschnitts der ersten leitenden Schicht (400), wobei die zweite Schutzschicht (401) und die dielektrische Schicht (901) als Isolationsschicht (110) der Gate-Struktur (100) dienen.

2. Verfahren zum Herstellen der Halbleiterstruktur nach Anspruch 1, wobei das Strukturieren (S11) der Passivierungsschicht (700) und der zweiten leitenden Schicht (600), um das primäre Gate-Muster (800) zu bilden, ferner Folgendes umfasst:
Bilden einer Maskenschicht (701) und einer Photoresistschicht (702) auf der Passivierungsschicht (700);
Strukturieren der Photoresistschicht (702), wobei die Photoresistschicht (702) in einem Bereich beibehalten wird, in dem das primäre Gate-Muster (800) gebildet werden muss;
Übertragen des Musters der Photoresistschicht (702) auf die Maskenschicht (701), um eine gemusterte Maskenschicht zu bilden;
Entfernen der Passivierungsschicht (700) und der zweiten leitenden Schicht (600) unter Verwendung der Maskenschicht (701) als Maske; und
Entfernen der Maskenschicht (701) und der Photoresistschicht (702), um das primäre Gate-Muster (800) zu bilden.

3. Verfahren zum Herstellen der Halbleiterstruktur nach Anspruch 1, wobei das primäre Gate-Muster (800) einer Plasmabehandlung unterzogen wird, indem eine mit Stickstoff und Sauerstoff gemischte Plasmabehandlung an der Seitenwand des primären Gate-Musters (800) ausgeführt wird.

4. Verfahren zum Herstellen der Halbleiterstruktur nach Anspruch 1, wobei das primäre Gate-Muster (800) der Plasmabehandlung durch in-situ-Plasmabehandlung unterzogen wird.

5. Verfahren zum Herstellen der Halbleiterstruktur nach Anspruch 1, wobei die Bildung der dielektrischen Schicht (901) an der Seitenwand des primären Gate-Musters (800) und der Seitenfläche der ersten Schutzschicht (601) ferner Folgendes umfasst:
Bilden einer anfänglichen dielektrischen Schicht (900) auf einer Oberfläche des primären Gate-Musters (800) und einer Oberfläche des freiliegenden Abschnitts der ersten leitenden Schicht (400); und
Entfernen eines Abschnitts der anfänglichen dielektrischen Schicht (900), um einen Abschnitt der anfänglichen dielektrischen Schicht (900) an der Seitenwand des primären Gate-Musters (800) beizubehalten, um als die dielektrische Schicht (901) zu dienen.

6. Verfahren zum Herstellen der Halbleiterstruktur nach Anspruch 5, wobei das Entfernen des freiliegenden Abschnitts der ersten leitenden Schicht (400), um den Abschnitt der ersten leitenden Schicht (400), der sich unter dem primären Gate-Muster (800) befindet, beizubehalten, ferner Folgendes umfasst:
Entfernen des freiliegenden Abschnitts der ersten leitenden Schicht (400), um das Halbleitersubstrat (200) freizulegen, wobei eine Seitenwand der ersten leitenden Schicht (400) freigelegt wird und ein Abschnitt der ersten leitenden Schicht (400), der von dem primären Gate-Muster (800) bedeckt ist, und die erste leitende Schicht (400) unterhalb der dielektrischen Schicht (901) an der Seitenwand des primären Gate-Musters (800) beibehalten wird; und
Entfernen der ersten leitenden Schicht (400) unterhalb der dielektrischen Schicht (901) an der Seitenwand des primären Gate-Musters (800) von der Seitenwand der ersten leitenden Schicht (400), wobei die erste leitende Schicht (400), die von dem primären Gate-Muster (800) bedeckt ist, beibehalten wird.

7. Verfahren zum Herstellen der Halbleiterstruktur nach Anspruch 1, wobei die Bildung der zweiten Schutzschicht (401) an einer Seitenwand des freiliegenden Abschnitts der ersten leitenden Schicht (400) durch epitaktisches Erzeugen der zweiten Schutzschicht (401) an der Seitenwand des freiliegenden Abschnitts der ersten leitenden Schicht (400) erfolgt.

8. Verfahren zum Herstellen der Halbleiterstruktur nach Anspruch 1, ferner umfassend ein Bilden einer Gate-Isolationsschicht (300) auf dem Halbleitersubstrat (200) umfasst, wobei sich die Gate-Isolationsschicht (300) zwischen dem Halbleitersubstrat (200) und der ersten leitenden Schicht (400) befindet, und
nach Bilden der zweiten Schutzschichten (401) ferner umfassend: Entfernen der Gate-Isolationsschicht (300), die weder von der ersten leitenden Schicht (400) noch von der zweiten Schutzschicht (401) bedeckt ist, um das Halbleitersubstrat (200) freizulegen.

9. Verfahren zum Herstellen der Halbleiterstruktur nach Anspruch 1, ferner umfassend ein Bilden einer Sperrschicht (500) zwischen der ersten leitenden Schicht (400) und der zweiten leitenden Schicht (600), und wobei beim Strukturieren der Passivierungsschicht (700) und der zweiten leitenden Schicht (600) die Sperrschicht (500) auch strukturiert wird.

10. Halbleiterstruktur, wobei die Halbleiterstruktur Folgendes umfasst:
ein Halbleitersubstrat (200);
eine Gate-Struktur (100), die sich auf dem Halbleitersubstrat (200) befindet, wobei die Gate-Struktur (100) eine erste leitende Schicht (400), eine zweite leitende Schicht (600) und eine Passivierungsschicht (700) umfasst, die übereinander angeordnet sind, und eine erste Schutzschicht (601) an einer Seitenwand der zweiten leitenden Schicht (600) angeordnet ist;
eine zweite Schutzschicht (401), die eine Seitenwand der ersten leitenden Schicht (400) bedeckt;
eine dielektrische Schicht (901), die Seitenwände der ersten Schutzschicht (601) und der Passivierungsschicht (700) bedeckt; und
eine Sperrschicht (500), die zwischen der ersten leitenden Schicht (400) und der zweiten leitenden Schicht (600) angeordnet ist;
wobei die Seitenflächen der ersten leitenden Schicht (400), der Sperrschicht (500), der ersten Schutzschicht (601) und der Passivierungsschicht (700) bündig sind.

11. Halbleiterstruktur nach Anspruch 10, ferner umfassend eine Gate-Isolierschicht (300), die zwischen dem Halbleitersubstrat (200) und der Gate-Struktur (100) angeordnet ist, und eine Seitenfläche der Gate-Isolierschicht (300) mit einer äußeren Seitenfläche der zweiten Schutzschicht (401) bündig ist.

12. Halbleiterstruktur nach Anspruch 10, wobei die Stärke der ersten Schutzschicht (601) 3 Angström bis 20 Angström ist.

13. Halbleiterstruktur nach Anspruch 10, wobei sowohl die dielektrische Schicht (901) als auch die Passivierungsschicht (700) Siliziumnitridschichten sind.

14. Halbleiterstruktur nach Anspruch 10, wobei eine äußere Seitenfläche der zweiten Schutzschicht (401) mit einer äußeren Seitenfläche der dielektrischen Schicht (901) bündig ist oder die zweite Schutzschicht (401) eine Siliciumcarbid-Epitaxieschicht ist.

## Revendications

1. Procédé de fabrication d'une structure semi-conductrice, le procédé comprenant :
la formation successive (S10) d'une première couche conductrice (400), d'une seconde couche conductrice (600) et d'une couche de passivation (700) sur un substrat semi-conducteur (200) ;
la formation de motifs (S11) sur la couche de passivation (700) et la seconde couche conductrice (600) pour former un motif de porte primaire (800), dans lequel une partie de la première couche conductrice (400) qui n'est pas recouverte par le motif de porte primaire (800) est exposée ;
la soumission (S12) du motif de porte primaire (800) à un traitement au plasma pour former une première couche de protection (601) sur une paroi latérale de la seconde couche conductrice (600) ;
la formation (S13) d'une couche diélectrique (901) sur une paroi latérale du motif de porte primaire (800) et une surface latérale de la première couche de protection (601) ;
l'élimination (S14) de la partie exposée de la première couche conductrice (400) pour réserver une partie de la première couche conductrice (400) recouverte par le motif de porte primaire (800) ; et
la formation (S15) d'une seconde couche de protection (401) sur une paroi latérale de la partie exposée de la première couche conductrice (400), dans lequel la seconde couche de protection (401) et la couche diélectrique (901) servent de couche d'isolation (110) de la structure de porte (100).

2. Procédé de fabrication de la structure semi-conductrice selon la revendication 1, dans lequel ladite formation de motifs (S11) sur la couche de passivation (700) et la seconde couche conductrice (600) pour former le motif de porte primaire (800) comprend en outre :
la formation d'une couche de masque (701) et d'une couche de résine photosensible (702) sur la couche de passivation (700) ;
la formation de motifs sur la couche de résine photosensible (702), dans lequel la couche de résine photosensible (702) est réservée dans une région où le motif de la porte primaire (800) doit être formé ;
le transfert du motif de la couche de résine photosensible (702) à la couche de masque (701) pour former une couche de masque à motifs ;
l'élimination de la couche de passivation (700) et de la seconde couche conductrice (600) en prenant la couche de masque (701) comme masque ; et
l'élimination de la couche de masque (701) et de la couche de résine photosensible (702) pour former le motif de porte primaire (800).

3. Procédé de fabrication de la structure semi-conductrice selon la revendication 1, dans lequel le motif de porte primaire (800) est soumis au traitement au plasma en effectuant un traitement au plasma mixte d'azote et d'oxygène sur la paroi latérale du motif de porte primaire (800).

4. Procédé de fabrication de la structure semi-conductrice selon la revendication 1, dans lequel le motif de porte primaire (800) est soumis au traitement au plasma par un traitement au plasma in situ.

5. Procédé de fabrication de la structure semi-conductrice selon la revendication 1, dans lequel la formation de la couche diélectrique (901) sur la paroi latérale du motif de porte primaire (800) et la surface latérale de la première couche de protection (601) comprend en outre :
la formation d'une couche diélectrique initiale (900) sur une surface du motif de porte primaire (800) et une surface de la partie exposée de la première couche conductrice (400) ; et
l'élimination d'une partie de la couche diélectrique initiale (900) pour réserver une partie de la couche diélectrique initiale (900) sur la paroi latérale du motif de porte primaire (800) pour servir de couche diélectrique (901).

6. Procédé de fabrication de la structure semi-conductrice selon la revendication 5, dans lequel ladite élimination de la partie exposée de la première couche conductrice (400) pour réserver la partie de la première couche conductrice (400) située sous le motif de porte primaire (800) comprend en outre :
l'élimination de la partie exposée de la première couche conductrice (400) pour exposer le substrat semi-conducteur (200), dans lequel une paroi latérale de la première couche conductrice (400) est exposée, et une partie de la première couche conductrice (400) recouverte par le motif de porte primaire (800) et la première couche conductrice (400) sous la couche diélectrique (901) sur la paroi latérale du motif de porte primaire (800) sont réservées ; et
l'élimination de la première couche conductrice (400) sous la couche diélectrique (901) sur la paroi latérale du motif de porte primaire (800) de la paroi latérale de la première couche conductrice (400), dans lequel la première couche conductrice (400) recouverte par le motif de porte primaire (800) est réservée.

7. Procédé de fabrication de la structure semi-conductrice selon la revendication 1, dans lequel la formation de la seconde couche de protection (401) sur une paroi latérale de la partie exposée de la première couche conductrice (400) est réalisée par génération épitaxique de la seconde couche de protection (401) sur la paroi latérale de la partie exposée de la première couche conductrice (400).

8. Procédé de fabrication de la structure semi-conductrice selon la revendication 1, comprenant en outre la formation d'une couche d'isolation de porte (300) sur le substrat semi-conducteur (200), dans lequel la couche d'isolation de porte (300) est située entre le substrat semi-conducteur (200) et la première couche conductrice (400), et
après avoir formé les secondes couches de protection (401), comprenant en outre : l'élimination de la couche d'isolation de porte (300) qui n'est recouverte ni par la première couche conductrice (400) ni par la seconde couche de protection (401) pour exposer le substrat semi-conducteur (200).

9. Procédé de fabrication de la structure semi-conductrice selon la revendication 1, comprenant en outre la formation d'une couche barrière (500) entre la première couche conductrice (400) et la seconde couche conductrice (600), et dans lequel lors de la formation de motifs sur la couche de passivation (700) et la seconde couche conductrice (600), des motifs sont également formés sur la couche barrière (500).

10. Structure semi-conductrice, dans laquelle la structure semi-conductrice comprend :
un substrat semi-conducteur (200) ;
une structure de porte (100) située sur le substrat semi-conducteur (200), dans laquelle la structure de porte (100) comprend une première couche conductrice (400), une seconde couche conductrice (600) et une couche de passivation (700) qui sont empilées, et une première couche de protection (601) sont agencées sur une paroi latérale de la seconde couche conductrice (600) ;
une seconde couche de protection (401) recouvrant une paroi latérale de la première couche conductrice (400) ;
une couche diélectrique (901) recouvrant les parois latérales de la première couche de protection (601) et de la couche de passivation (700) ; et
une couche barrière (500) agencée entre la première couche conductrice (400) et la seconde couche conductrice (600) ;
dans laquelle les surfaces latérales de la première couche conductrice (400), de la couche barrière (500), de la première couche de protection (601) et de la couche de passivation (700) sont alignées.

11. Structure semi-conductrice selon la revendication 10, comprenant en outre une couche d'isolation de porte (300) agencée entre le substrat semi-conducteur (200) et la structure de porte (100), et une surface latérale de la couche d'isolation de porte (300) est alignée avec une surface latérale externe de la seconde couche de protection (401).

12. Structure semi-conductrice selon la revendication 10, dans laquelle une épaisseur de la première couche de protection (601) est de 3 angströms à 20 angströms.

13. Structure semi-conductrice selon la revendication 10, dans laquelle la couche diélectrique (901) et la couche de passivation (700) sont des couches de nitrure de silicium.

14. Structure semi-conductrice selon la revendication 10, dans laquelle une surface latérale externe de la seconde couche de protection (401) est alignée avec une surface latérale externe de la couche diélectrique (901), ou la seconde couche de protection (401) est une couche épitaxiale de carbure de silicium.
